# EUROPÄISCHE PATENTSCHRIFT

(11) **EP 0 788 226 B1**
(45) Veröffentlichungstag und Bekanntmachung des Hinweises auf die Patenterteilung: **12.07.2000**
(21) Anmeldenummer: 97100901.4
(22) Anmeldetag: 22.01.1997
(51) Int. Cl.: H03J 7/24, H03D 5/00

(54) **Schaltungsanordnung eines Rundfunkempfängers**
Radio receiver circuit
Circuit de récepteur de radio

(30) Priorität: 02.02.1996 DE 19603721
(43) Veröffentlichungstag der Anmeldung: 06.08.1997
(73) Patentinhaber: TEMIC Semiconductor GmbH, 74072 Heilbronn (DE)
(72) Erfinder: Rebel, Reimund, 75031 Eppingen (DE); Rinderle, Heinz, 74080 Heilbronn (DE); Sapotta, Hans, Dr., 74078 Heilbronn (DE)
(74) Vertreter: Maute, Hans-Jürgen, Dipl.-Ing.

(56) Entgegenhaltungen:
- EP-A- 0 015 706
- US-A- 4 580 285
- PATENT ABSTRACTS OF JAPAN vol. 004, no. 189 (E-039), 25.Dezember 1980 & JP 55 130220 A (SHARP CORP), 8.Oktober 1980,

## Beschreibung

In zunehmenden Maße werden Rundfunkempfänger digital auf die Eingangsfrequenz eines Senders bzw. auf die beim Empfang eines Senders gebildete Zwischenfrequenz abgestimmt (die Zwischenfrequenz ZF ist die Frequenzdifferenz aus einer Oszillatorfrequenz und der Eingangsfrequenz, beispielsweise im FM-Betrieb 10,7 MHz). Dies ist insbesondere bei Radiogeräten mit Sendersuchlauf oder mit RDS ("Radio Data System": Anzeige der Senderfrequenz, des Sendernamens und automatisches umschalten auf einen besser zu empfangenden äquivalenten Sender) von Bedeutung, da hier die Empfangsstufe des RundfunKempfängers exakt auf die unterschiedliche Frequenz des jeweiligen Senders gerastert werden muß. Hierzu wird während des Abstimmvorgangs (Sendersuchlauf) die Frequenz mit einer vorgegebenen Schrittweite variiert und das auf den jeweiligen Frequenzen erhaltene Empfangssignal anhand bestimmter Kriterien bewertet; beim Erkennen eines in guter oder mit ausreichender Qualität zu empfangenden Senders wird mittels eines Sendersuchlaufstopsignals ein Sendersuchlaufstop generiert.
Im FM-Betrieb wird der (FM-) Sendersuchlauf in einfachen Rundfunkempfängern allein anhand der Feldstärkeinformation der FM-Empfangsstufe bewertet: wenn auf einer Frequenz das Feldstärkesignal des Empfangssignals einen vorgegebenen Schwellwert-Pegel überschreitet, wird von einer Stopsignalgeneratorstufe ein Sendersuchlaufstopsignal erzeugt, das einer PLL-Schaltung zugeführt wird und den Sendersuchlauf unterbricht (Sendersuchlaufstop); aufgrund geringer Frequenzabstände der verschiedenen Sender und nicht ausreichender Nachbarkanaltrennung im Rundfunkempfänger wird jedoch häufig ein Sendersuchlaufstop ausgelöst, ohne daß die richtige Frequenz getroffen wurde (ein sog. "Fehlstop"). Daher wird oftmals zusätzlich zum Feldstärkesignal eine Diskriminatorspannung als Spannung eines für die FM-Empfangsfunktion benötigten Frequenzdiskriminators (Frequenzdemodulators) der FM-Empfangsstufe (beispielsweise der FM-Demodulator der FM-Empfangsstufe) bewertet, wobei die Feldstärkeinformation und die frequenzabhängige Spannungsinformation des Frequenzdiskriminators (Frequenzinformation) der FM-Empfangsstufe logisch miteinander verknüpft werden: erst wenn sowohl ein adäquates Feldstärkesignal als auch eine adäquate mittlere Diskriminatorspannung für die "Soll-Zwischenfrequenz" des empfangenen Signals vorliegen, wird ein Sendersuchlaufstopsignal erzeugt und der Sendersuchlaufstop ausgelöst. Eine weitere Möglichkeit besteht darin, den Sendersuchlauf digital mittels ZF-Zählung zu bewerten: die Zwischenfrequenz auf der ZF-Ebene wird mit Hilfe eines Frequenzzählers im ZF-Verstärker (dem sog. "ZF-Zähler") digital bestimmt und ausgewertet; beim Erreichen der Zwischenfrequenz wird ein sendersuchlaufstopsignal erzeugt und der Sendersuchlaufstop ausgelöst. Obwohl die Zwischenfrequenz quarzgenau und damit temperaturunabhängig exakt bestimmt werden kann, wird wegen des erhöhten Hardware-Aufwands, der EMV-Probleme beim Betrieb des Frequenzzählers und der Möglichkeit von Fehlstops zwischen zwei gleich starken Sendern, der Sendersuchlauf im FM-Bereich in der Regel über die gemeinsame Bewertung der bereits von anderen Schaltungskomponenten der FM-Empfangsstufe gelieferten Informationen Feldstärkesignal und Diskriminatorspannung durchgeführt.
im AM-Betrieb wird für den (AM-) Sendersuchlauf üblicherweise nur die Feldstärkeinformation bewertet, da in der AM-Empfangsstufe ein Frequenzdiskriminator für die AM-Empfangsfunktion nicht benötigt wird und somit auch keine Information über eine Diskriminatorspannng vorliegt. um eine vernünftige Generierung des AM-Sendersuchlaufstops zu ermöglichen, muß auch im AM-Betrieb zusätzlich eine frequenzabhängige Spannungsinformation herangezogen werden; hierzu müssen zusätzliche Schaltungselemente vorgesehen werden, die Informationen über die Zwischenfrequenz (ZF) liefern:
- beispielsweise kann im AM-Betrieb für die Generierung der frequenzabhängigen Spannungsinformation bzw. des Frequenzsignals (ähnlich wie im FM-Betrieb) ein Frequenzdiskriminator eingesetzt werden, wobei hierfür beispielsweise der FM-ZF-Verstärker und FM-Diskriminator der FM-Empfangsstufe verwendet wird. In diesem Falle wird das AM-ZF-Signal von der AM-Empfangsstufe in den FM-ZF-Verstärker der FM-Empfangsstufe eingekoppelt, verstärkt und begrenzt. Das Frequenzsignal wird dabei üblicherweise in einem Produktdetektor erzeugt, der aus einem Multiplizierer, einem Phasenkreis für die FM-ZF und einem Phasenkreis für die AM-ZF besteht (der Phasenkreis für die AM-ZF kann beispielsweise ein LC-Schwingkreis sein, der in Reihe zum Phasenkreis für die FM-ZF geschaltet ist). In der Stopsignalgeneratorstufe wird - nach Glättung von Feldstärkesignal und Frequenzsignal - mittels logischer Verknüpfung das Sendersuchlaufstopsignal generiert. Als Feldstärkesignal kann hierbei auch das bei der Verstärkungsregelung im AM-Betrieb anfallende Regelsignal ausgewertet werden.
- bei einer anderen Möglichkeit wird das AM-ZF-Signal in einer Selektionsschaltung einer zusätzlichen, schmalbandigen Selektion unterzogen, wobei die Resonanzspitze innerhalb des ZF-Durchlaßbereiches liegt; am Ausgang der Selektionsschaltung entsteht während des Sendersuchlaufs ein Gleichsignal, das in der Stopsignalgeneratorstufe ausgewertet wird. Beim Überschreiten eines Schwellwerts wird durch logische Verknüpfung mit dem Feldstärkesignal ggf. ein Sendersuchlaufstopsignal erzeugt. um eine schmalbandige Selektion zu erreichen, werden in der Selektionsschaltung üblicherweise Keramikresonatoren als frequenzbestimmende Bauelemente eingesetzt, da diese eine hohe Resonanzgüte aufweisen.

Diese bekannten Vorschläge (siehe z.B. US-A-4 580 285) zur Generierung eines sicheren AM-Sendersuchlaufstops benötigen jedoch stets zusätzliche frequenzbestimmende Bauelemente (LC-Kreis oder Keramikresonator), gegebenenfalls einen zusätzlichen Abgleich und verursachen damit Mehrkosten.

Der Erfindung liegt die Aufgabe zugrunde, eine Schaltungsanordnung gemäß dem Oberbegriff des Patentanspruchs 1 anzugeben, bei dem ein Sendersuchlauf im AM-Betrieb auf einfache Weise möglich ist und das (AM-) Sendersuchlaufstopsignal ohne großen zusätzlichen Aufwand an Schaltungsmitteln und Kosten zuverlässig generierbar ist.

Diese Aufgabe wird erfindungsgemäß durch die Merkmale im Kennzeichen des Patentanspruchs 1 gelöst.

Vorteilhafte Weiterbildungen und Ausgestaltungen der Erfindung ergeben sich aus den unteransprüchen.

Bei der erfindungsgemäßen Schaltungsanordnung eines Rundfunkempfängers wird in der der FM-Empfangsstufe und der AM-Empfangsstufe nachgeschalteten Multiplex-Stereodekoderstufe (MPX-Stereodekoderstufe) zur Regeneration des Stereoträgers (38 kHz) eine PLL-Schaltung mit einem von einem Keramikresonator der Frequenz 456 kHz angesteuerten VCO (Sollfrequenz 456 kHz) eingesetzt, und dieser Keramikresonator auch als frequenzbestimmendes Bauelement zur Generierung der Frequenzinformation für den AM-Sendersuchlauf herangezogen. Hierzu weist die Stopsignalgeneratorstufe eine Frequenzschaltung auf, deren Frequenzeingang mit dem Keramikresonator der Frequenz 456 kHz verbunden ist bzw. über ein Schaltelement mit dem Keramikresonator der Frequenz 456 kHz verbunden werden kann; der Keramikresonator der Frequenz 456 kHz ist somit (ggf. über das Schaltelement) mit dem VCO der MPX-Stereodekoderstufe und/oder mit der Stopsignalgeneratorstufe verbunden.
Beim AM-Sendersuchlauf wird der Keramikresonator (ggf. über das beispielsweise als elektronischer Umschalter ausgebildete Schaltelement) mit der Stopsignalgeneratorstufe verbunden und liefert die Frequenzinformation für die Frequenzschaltung der Stopsignalgeneratorstufe: der Keramikresonator kann somit beispielsweise als frequenzbestimmendes Bauelement zur Generierung der Frequenzinformation in einer als (AM-ZF-) Frequenzdiskriminatorschaltung ausgebildeten Frequenzschaltung oder beispielsweise als Selektionselement in einer als (AM-ZF-) Selektionsschaltung ausgebildeten Frequenzschaltung wirksam werden. Zur Einstellung der jeweils für die korrekte Funktion des AM-Sendersuchlaufs erforderlichen Resonanzfrequenz (beispielsweise 455 kHz als AM-ZF) kann ein Ziehkondensator vorgesehen werden, der dem Keramikresonator parallelgeschaltet ist bzw. über das schaltelement parallelgeschaltet werden kann und mit diesem einen Resonanzkreis bildet. Die Kapazität des Ziehkondensators kann mechanisch (Trimmkondensatoren) oder elektronisch eingestellt bzw. verändert werden. Bei elektronisch einstellbarem Ziehkondensator (beispielsweise eine Varaktordiode, deren Kapazitätswert über eine variable Gleichspannung gesteuert wird) kann der Abgleich der Parallelresonanz bzw. der Serienresonanz bezüglich des Frequenzeingangs der Frequenzschaltung automatisch im Produktionsprozeß durchgeführt werden; als Kriterium für den richtigen Abgleich kann beispielsweise die Generierung des Sendersuchlaufstopsignals beim Einspeisen eines AM-ZF-Signals mit der Sollfrequenz in die AM-Empfangsstufe herangezogen werden. Durch eine angemessene Vorgabe der Frequenztoleranz des Keramikresonators in Verbindung mit einer "angepaßten" (reduzierten) Resonanzschärfe des am Frequenzeingang der Frequenzschaltung wirksamen Resonanzkreises kann eine ausreichende Zuverlässigkeit bei der Generierung des Sendersuchlaufstopsignals ohne zusätzlichen Abgleichvorgang erreicht werden. Die Parallelresonanz- bzw. Serienresonanzfrequenz des Resonanzkreises aus Keramikresonator und Ziehkondensator kann mittels eines dem Steueranschluß des Ziehkondensators zugeführten (einstellbaren) Gleichspannungssignals oder (einstellbaren) Gleichstromsignals erfolgen, durch das der Kapazitätswert des Ziehkondensators variiert wird.

Da der bereits vorhandene Keramikresonator als frequenzbestimmendes Bauelement für die Frequenzschaltung der Stopsignalgeneratorstufe beim AM-Sendersuchlauf eingesetzt wird, kann die Schaltungsanordnung des Rundfunkempfängers auf einfache Weise und ohne großen Mehraufwand an Schaltungsmitteln und Kosten realisiert werden.

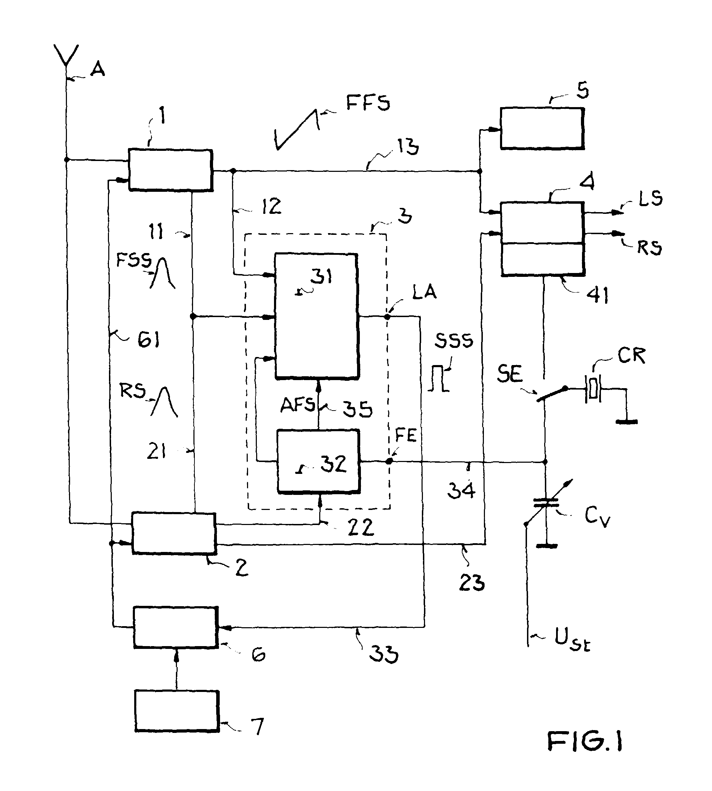

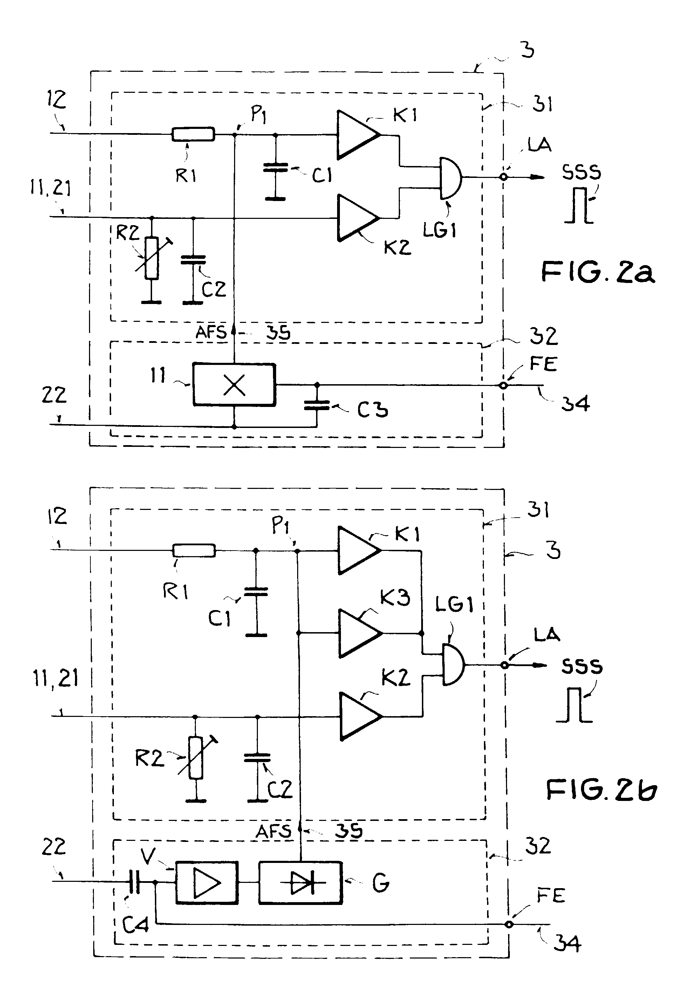

Die erfindungsgemäße Schaltungsanordnung des Rundfunkempfängers wird anhand der Zeichnung beschrieben, wobei in der Figur 1 das Blockschaltbild des Rundfunkempfängers dargestellt ist und die Figuren 2a und 2b zwei verschiedene Ausführungsformen der Stopsignalgeneratorstufe zeigen.

Gemäß dem Blockschaltbild der Figur 1 besteht der Rundfunkempfänger aus der FM-Empfangsstufe 1, der AM-Empfangsstufe 2, der Stopsignalgeneratorstufe 3, der MPX-Stereodekoderstufe 4, der RDS-Dekoderstufe 5, der PLL-Stufe 6 und dem Mikroprozessor 7.

In der FM-Empfangsstufe 1 wird das von der Antenne A empfangene FM-Eingangssignal einem FM-Tuner zugeführt, der hieraus ein breitbandiges FM-ZF-Signal der Frequenz 10,7 MHz erzeugt, das infolge der Filterung mit einem FM-ZF-Filter (Filterfrequenz 10,7 MHz) schmalbandig gemacht wird; dieses schmalbandige FM-ZF-Signal wird einem FM-ZF-Verstärker zugeführt, der ein begrenztes FM-ZF-Signal generiert. Das begrenzte FM-ZF-Signal wird einem FM-Diskriminator der FM-Empfangsstufe 1 zugeführt. Aus diesem begrenzten FM-ZF-Signal erzeugt der FM-ZF-Verstärker das Feldstärkesignal FSS, das über die Verbindungsleitung 11 der Logikschaltung 31 der Stopsignalgeneratorstufe 3 als Feldstärkesignal FSS zur Bereitstellung der Feldstärkeinformation zugeführt wird. Das Ausgangssignal des FM-Diskriminators wird einerseits über die Verbindungsleitung 13 der MPX-Stereodekoderstufe 4 und der RDS-Dekoderstufe 5, und andererseits über die Verbindungsleitung 12 der Stopsignalgeneratorstufe 3 als Frequenzsignal FS zur Bereitstellung der Spannungsinformation (Frequenzinformation) zugeführt (von der MPX-Stereodekoderstufe 4 wird das im Frequenzsignal FS enthaltene Multiplexsignal in die beiden Stereo-Ausgangssignale RS, LS dekodiert, von der RDS-Dekoderstufe 5 wird das um 57 kHz im Frequenzsignal FS gelegene RDS-Signal ausgewertet). Falls das der Logikschaltung 31 der Stopsignalgeneratorstufe 3 zugeführte Feldstärkesignal FSS einen bestimmten Schwellwert überschreitet und falls gleichzeitig das von der Frequenzschaltung 32 der Stopsignalgeneratorstufe 3 generierte Frequenzsignal AFS gültig wird (ein Eingangssignal innerhalb definierter Frequenzgrenzen anzeigt), wird am Ausgang LA der Logikschaltung 31 ein Sendersuchlaufstopsignal SSS ausgegeben; das Sendersuchlaufstopsignal SSS wird der vom Mikroprozessor 7 angesteuerten PLL-Stufe 6 über die Verbindungsleitung 33 zugeführt und hierdurch über die Verbindungsleitung 61 ein (FM-) Sendersuchlaufstop in der FM-Empfängerstufe 1 generiert.

In der AM-Empfangsstufe 2 wird das von der Antenne A empfangene AM-Eingangssignal einem AM-Tuner zugeführt, der hieraus ein breitbandiges AM-ZF-Signal der Frequenz 455 kHz erzeugt, das infolge der Filterung mit einem AM-ZF-Filter (Filterfrequenz 455 kHz) schmalbandig gemacht wird; dieses schmalbandige AM-ZF-Signal wird einem AM-ZF-Verstärker zugeführt, der ein geregeltes AM-ZF-Signal (Regelsignal RS) generiert. Dieses Regelsignal RS wird einerseits einem AM-Gleichrichter und andererseits über die Verbindungsleitung 21 der Logikschaltung 31 der Suchlaufstopgeneratorstufe 3 zur Bereitstellung der Feldstärkeinformation zugeführt; das schmalbandige AM-ZF-Signal wird über die Verbindungsleitung 22 der Frequenzschaltung 32 der Stopsignalgeneratorstufe 3 zugeführt, und mit dem eine Frequenzinformation beinhaltenden Ausgangssignal der Frequenzschaltung 32 als (AM-) Frequenzsignal AFS die Logikschaltung 31 der Stopsignalgeneratorstufe 3 über die Verbindungsleitung 35 beaufschlagt. Das Ausgangssignal des AM-Gleichrichters wird als tonfrequentes Signal der MPX-Stereodekoderstufe 4 über die Verbindungsleitung 23 zugeführt und in der MPX-Stereodekoderstufe 4 zu den Ausgängen für die Stereo-Ausgangssignale RS, LS durchgeschleift. Falls das der Logikschaltung 31 der Stopsignalgeneratorstufe 3 zugeführte Regelsignal RS einen bestimmten Schwellwert überschreitet und falls gleichzeitig das von der Frequenzschaltung 32 der Stopsignalgeneratorstufe 3 generierte Frequenzsignal AFS gültig wird (d. h. ein AM-Eingangssignal innerhalb definierter Frequenzgrenzen anzeigt), wird am Ausgang LA der Logikschaltung 31 ein Sendersuchlaufstopsignal SSS ausgegeben, mittels dessen über die PLL-Stufe 6 und die Verbindungsleitung 61 ein (AM-) Sendersuchlaufstop in der AM-Empfangsstufe 2 generiert wird. Die zur Generierung der Frequenzinformation für den AM-Sendersuchlauf von der Frequenzschaltung 32 benötigte Frequenzbestimmung wird dadurch realisiert, daß der Frequenzeingang FE der Frequenzschaltung 32 über die Verbindungsleitung 34 an einen Resonanzkreis aus Ziehkondensator C_{V} und Keramikresonator C_{R} direkt angeschlossen ist bzw. im AM-Betrieb über ein Schaltelement SE angeschlossen ist. Beim Vorhandensein eines Schaltelements SE ist der erste Schaltanschluß des Schaltelements SE in der einen Schalterstellung mit dem VCO 41 der MPX-Stereodekoderstufe 4 und in der anderen Schalterstellung mit der Frequenzschaltung 32 und dem Ziehkondensator C_{V} verbunden, der zweite Schaltanschluß des Schaltelements SE mit dem Keramikresonator C_{R} der Frequenz 456 kHz; der zweite Anschluß des Ziehkondensators C_{V} ist an Bezugspotential angeschlossen, der Steueranschluß des Ziehkondensators C_{V} wird mit einer (externen) Steuerspannung U_{St} als Ziehspannung zum Einstellen der Suchlaufstopmitte (Bandmittenfrequenz beispielsweise 455 kHz) beaufschlagt. Mittels des Schaltelements SE kann die Frequenz des Keramikresonators C_{R} somit entweder für den VCO 41 der MPX-Stereodekoderstufe 4 (FM-Betrieb) oder für die Frequenzschaltung 32 der Stopsignalgeneratorstufe 3 (AM-Betrieb) bereitgestellt werden: in der einen Schalterstellung des Schaltelements SE (AM-Betrieb) wird der Keramikresonator C_{R} mittels des Ziehkondensators C_{V} beispielsweise auf die Frequenz 455 kHz eingestellt und diese Frequenzinformation der Frequenzschaltung 32 zugeführt, die diese Frequenz mit der ZF-Frequenz von 455 kHz vergleicht; in der anderen Schalterstellung des Schaltelements SE (FM-Betrieb) wird der Keramikresonator C_{R} auf seiner Sollfrequenz 456 kHz belassen und diese Frequenzinformation der MPX-Stereodekoderstufe 4 zugeführt (diese Frequenzinformation wird als geradzahliges Vielfaches der Pilottonfrequenz von 19 kHz zur Dekodierung des RS- und LS-Signals benötigt).

Als Ziehkondensator C_{V} kann ggf. auch der für die Abstimmung des VCOs 41 der MPX-Stereodekoderstufe 4 eingesetzte Ziehkondensator verwendet oder mitverwendet werden, so daß in diesem Falle das Schaltelement SE nicht benötigt wird und der Keramikresonator C_{R} direkt an den Frequenzeingang FE der Frequenzschaltung 32 der Stopsignalgeneratorstufe 3 angeschlossen ist.

In der Figur 2 sind zwei Ausführungsbeispiele der Stopsignalgeneratorstufe 3 dargestellt.

Gemäß der Figur 2a besteht die Stopsignalgeneratorstufe 3 aus der Logikschaltung 31 und der als AM-Frequenzdiskriminatorschaltung ausgebildeten Frequenzschaltung 32. Die Logikschaltung 31 enthält einen ersten Komparator K1, einen zweiten Komparator K2, eine UND-Schaltung LG1, ein erstes RC-Glied (Kondensator C1, Widerstand R1) und ein zweites RC-Glied (Kondensator C2, Widerstand R2). Der erste Komparator K1 ist als Fensterkomparator ausgeführt, der als Frequenzinformation (Frequenzsignal) den Nulldurchgang des FM-Diskriminators über die Verbindungsleitung 12 (FM-Betrieb) und den Nulldurchgang der AM-Frequenzdiskriminatorschaltung 32 (AM-Frequenzsignal AFS) über die Verbindungsleitung 35 (AM-Betrieb) registriert (dem Knotenpunkt P1 der Logikschaltung 31 wird über die Verbindungsleitung 12 ein Spannungssignal und über die Verbindungsleitung 35 als AM-Frequenzsignal AFS ein Stromsignal zugeführt). Das erste RC-Glied Widerstand R1, Kondensator C1 dient in beiden Betriebsarten (AM-Betrieb, FM-Betrieb) zur (niederfrequenten) Glättung des jeweiligen Frequenzsignals. Der zweite Komparator K2 ist als Schwellwertkomparator ausgeführt, der als Feldstärkeinformation das auf der Verbindungsleitung 11, 21 anstehende Feldstärkesignal auswertet: am Ausgang des zweiten Komparators K2 wird dann ein Wahrheitssignal an die UND-Schaltung LG1 abgegeben, wenn das Feldstärkesignal einen vorgegebenen Schwellwert überschreitet. Die Logikschaltung 31 generiert am Ausgang LA dann ein Suchlaufstopsignal SSS, wenn die beiden Eingänge der UND-Schaltung LG1 gleichzeitig Wahrheitssignale (beispielsweise "High"-Signale) von den Ausgängen der beiden Komparatoren K1 und K2 erhalten. Das zweite RC-Glied Widerstand R2, Kondensator C2 dient einerseits zur (niederfrequenten) Glättung des Feldstärkesignals und andererseits über den Wert des (variablen) Widerstandes R2 zur Beeinflussung der Ansprechschwelle des Sendersuchlaufstops hinsichtlich der Empfangsfeldstärke, wobei für den AM-Betrieb und den FM-Betrieb der Wert des Widerstands R2 (und demzufolge die Ansprechschwelle) unterschiedlich bemessen werden kann. Mittels der AM-Frequenzdiskriminatorschaltung 32 wird das AM-Frequenzsignal AFS (Diskriminatorsignal) für den AM-Sendersuchlauf generiert. Hierzu wird beispielsweise ein Produktdetektor aus dem Multiplizierer 11, dem Kopplungskondensator C3 und dem am Frequenzeingang FE wirksamen Resonanzkreis mit dem frequenzbestimmenden Keramikresonator C_{R} verwendet. Das AM-ZF-Signal wird von der AM-Empfangsstufe 2 der AM-Frequenzdiskriminatorschaltung 32 über die Verbindungsleitung 22 zugeführt. Der Keramikresonator C_{R} ist mittels des Ziehkondensators C_{V} beispielsweise auf die Sollfrequenz der AM-Zwischenfrequenz (455 kHz) abgeglichen.

Gemäß der Figur 2b besteht die Stopsignalgeneratorstufe 3 aus der Logikschaltung 31 und der als Selektionsschaltung ausgebildeten Frequenzschaltung 32. In der Logikschaltung 31 ist gegenüber der anhand der Figur 2a beschriebenen Logikschaltung ein zusätzlicher, als Schwellwertkomparator ausgebildeter Komparator K3 zur Bewertung des von der Selektionsschaltung 32 erzeugten Signals vorgesehen; der nur im AM-Betrieb wirksame Schwellwertkomparator K3 (der erste Komparator K1 ist dann unwirksam) liefert dann ein Wahrheitssignal an die UND-Schaltung LG1, wenn das von der Selektionsschaltung 32 über die Verbindungsleitung 35 abgegebene AM-Frequenzsignal AFS (Stromsignal) einen bestimmten Schwellwert überschreitet. Die Logikschaltung 31 generiert am Ausgang LA dann ein Suchlaufstopsignal SSS, wenn die beiden Eingänge der UND-Schaltung LG1 gleichzeitig Wahrheitssignale (beispielsweise "High"-Signale) von den Ausgängen der beiden Komparatoren K1 und K2 (FM-Betrieb) bzw. der beiden Komparatoren K2 und K3 (AM-Betrieb) erhalten. Mittels der Selektionschaltung 32 aus dem Kopplungskondensator C4, dem Verstärker V und dem Gleichrichter G wird ein gegenüber der Bandbreite des AM-ZF-Signals schmalbandiges Frequenzsignal erzeugt. Hierzu wird das AM-ZF-Signal über die Verbindungsleitung 22 dem Eingang der Selektionsschaltung und über den Kopplungskondensator C4 dem an Frequenzeingang FE wirksamen (Parallel-) Resonanzkreis aus Keramikresonator C_{R} und Ziehkondensator C_{V} zugeführt (dieser dient in diesem Falle zum Abgleich der Parallelresonanz auf die Bandmittenfrequenz) und selektiert; das selektierte Frequenzsignal wird mittels des Verstärkers V verstärkt und im Gleichrichter G gleichgerichtet und der Logikschaltung 31 als AM-Frequenzsignal AFS über die Verbindungsleitung 35 zur Verfügung gestellt.

Bei einer anderen Variante der Selektionsschaltung 32 kann die Serienresonanz des frequenzbestimmenden Keramikresonators C_{R} zur Erzeugung des AM-Frequenzsignals AFS (Stromsignals) verwendet werden, indem mittels eines Ziehkondensators eine Serien resonanz auf der Sollfrequenz der AM-ZF erzeugt wird. Bei entsprechender Ausbildung des Verstärkers V wird die sonst vorhandene Signalgegenkopplung für die Signalfrequenzen um die Serienresonanz unterdrückt, wodurch die Verstärkung des Verstärkers V bei der Frequenz der Serienresonanz ein ausgeprägtes Maximum aufweist. Zur Einstellung der Serienresonanzfrequenz kann entweder ein in Reihe zum Keramikresonator C_{R} angeordneter zweiter Ziehkondensator oder der erste Ziehkondensator verwendet werden, falls ein weiterer (nicht-abstimmbarer) Kondensator in Serie zum Keramikresonator geschaltet wird.

## Patentansprüche

1. Schaltungsanordnung eines Rundfunkempfängers mit:
- einer FM-Empfangsstufe (1) für den FM-Betrieb,
- einer AM-Empfangsstufe (2) für den AM-Betrieb,
- einer Stopsignalgeneratorstufe (3) zur Generierung eines Sendersuchlaufstopsignals (SSS) für den Sendersuchlauf mittels eines Feldstärkesignals (FSS, RS) und eines Frequenzsignals (FS),
- einer Multiplex-Stereodekoderstufe (4) mit einem mittels eines Keramikresonators (C_{R}) einer bestimmten Resonanzfrequenz angesteuerten VCO (41),
dadurch gekennzeichnet:
- die Stopsignalgeneratorstufe (3) weist eine Frequenzschaltung (32) mit einem Frequenzeingang (FE) zur Erzeugung des Frequenzsignals (AFS) für den AM-Sendersuchlauf und eine Logikschaltung (31) zur Generierung des Sendersuchlaufstopsignals (SSS) auf,
- der Frequenzeingang (FE) der Frequenzschaltung (32) der Stopsignalgeneratorstufe (3) ist im AM-Betrieb zur Generierung des Sendersuchlaufstopsignals (SSS) mit einem Resonanzkreis aus einem Ziehkondensator (C_{V}) mit variierbarer Kapazität und dem eine Resonanzfrequenz von 456 kHz aufweisenden Keramikresonator (C_{R}) verbunden.

2. Schaltungsanordnung nach Anspruch 1, dadurch gekennzeichnet, daß der Frequenzeingang (FE) der Frequenzschaltung (32) der Stopsignalgeneratorstufe (3) mit dem Ziehkondensator (C_{V}) direkt und mit dem Keramikresonator (C_{R}) über ein Schaltelement (SE) mit zwei Schaltanschlüssen verbunden ist.

3. Schaltungsanordnung nach Anspruch 1, dadurch gekennzeichnet, daß der Frequenzeingang (FE) der Frequenzumschaltung (32) der Stopsignalgeneratorstufe (3) direkt mit dem Keramikresonator (C_{R}) und dem als Ziehkondensator für den VCO (41) der MPX-Stereodekoderstufe (4) eingesetzten Ziehkondensator (C_{V}) verbunden ist.

4. Schaltungsanordnung nach einem der Ansprüche 1 bis 3, dadurch gekennzeichnet, daß die Frequenzschaltung (32) der Stopsignalgeneratorstufe (3) als AM-Frequenzdiskriminatorschaltung ausgebildet ist.

5. Schaltungsanordnung nach einem der Ansprüche 1 bis 3, dadurch gekennzeichnet, daß die Frequenzschaltung (32) der Stopsignalgeneratorstufe (3) als Selektionsschaltung ausgebildet ist.

6. Schaltungsanordnung nach Anspruch 5, dadurch gekennzeichnet, daß im Resonanzkreis der Keramikresonator (C_{R}) und der Ziehkondensator (C_{V}) parallelgeschaltet sind, so daß zur Erzeugung des Frequenzsignals (AFS) für den AM-Sendersuchlauf die Parallelresonanz von Keramikresonator (C_{R}) und Ziehkondensator (C_{V}) bestimmend ist.

7. Schaltungsanordnung nach Anspruch 5, dadurch gekennzeichnet, daß im Resonanzkreis der Keramikresonator (C_{R}) und der Ziehkondensator (C_{V}) in Serie geschaltet sind, so daß zur Erzeugung des Frequenzsignals (AFS) für den AM-Sendersuchlauf die Serienresonanz von Keramikresonator (C_{R}) und Ziehkondensator (C_{V}) bestimmend ist.

8. Schaltungsanordnung nach einem der Ansprüche 1 bis 7, dadurch gekennzeichnet, daß der Ziehkondensator (C_{V}) als Trimmkondensator ausgebildet ist.

9. Schaltungsanordnung nach einem der Ansprüche 1 bis 7, dadurch gekennzeichnet, daß der Ziehkondensator (C_{V}) als elektronisches Bauelement oder elektronische Schaltung ausgebildet ist.

10. Schaltungsanordnung nach Anspruch 9, dadurch gekennzeichnet, daß der Ziehkondensator (C_{V}) als Varaktordiode ausgebildet ist.

11. Schaltungsanordnung nach einem der Ansprüche 1 bis 10, dadurch gekennzeichnet, daß der Steueranschluß des Ziehkondensators (C_{V}) mit einer Gleichspannungsquelle oder Gleichstromquelle verbunden ist, so daß der Frequenzabgleich bei der Generierung des Frequenzsignals (AFS) für den AM-Sendersuchlauf durch ein am Steueranschluß des Ziehkondensators (C_{V}) angelegtes Gleichspannungssignal (U_{St}) oder Gleichstromsignal erfolgt.

12. Schaltungsanordnung nach einem der Ansprüche 1 bis 11, dadurch gekennzeichnet, daß die Frequenzschaltung (32) der Stopsignalgeneratorstufe (3) als Frequenzsignal (AFS) ein Stromsignal erzeugt, mit dem die Logikschaltung (31) der Stopsignalgeneratorstufe (3) über eine verbindungsleitung (35) beaufschlagbar ist.

13. Schaltungsanordnung nach Anspruch 1 und 12, dadurch gekennzeichnet, daß die Logikschaltung (31) der Stopsignalgeneratorstufe (3) zur niederfrequenten Glättung des Frequenzsignals (AFS) für den AM-Sendersuchlauf und des Frequenzsignals (FFS) für den FM-Sendersuchlauf ein erstes RC-Glied (R1, C1) aufweist.

14. Schaltungsanordnung nach einem der Ansprüche 1, 12 oder 13, dadurch gekennzeichnet, daß das Feldstärkesignal (RS) für den AM-Sendersuchlauf und das Feldstärkesignal (FSS) für den FM-Sendersuchlauf jeweils als Stromsignal ausgebildet ist, und daß die Logikschaltung (31) der Stopsignalgeneratorstufe (3) zur niederfrequenten Glättung der Feldstärkesignale (FSS, RS) ein zweites RC-Glied (R2, C2) aufweist.

15. Schaltungsanordnung nach Anspruch 1 oder 14, dadurch gekennzeichnet, daß die Logikschaltung (31) zur Variation der Ansprechschwelle der Feldstärkesignale (FSS, RS) bei der Generierung des Sendersuchlaufstopsignals (SSS) einen einstellbaren Widerstand (R2) aufweist.

## Claims

1. Circuit arrangement of a radio receiver with:
- a FM receiver stage (1) for FM operation,
- an AM receiver stage (2) for AM operation,
- a stop signal generator stage (3) for generating a station search run stop signal (SSS) for the station search run by means of a field strength signal (FSS, RS) and a frequency signal (FS),
- a multiplex stereo decoder stage (4) with a VCO (41) driven by means of a ceramic resonator (C_{R}) of a certain resonant frequency,
characterised in that:
- the stop signal generator stage (3) comprises a frequency circuit (32) with a frequency input (FE) for generating the frequency signal (AFS) for the AM station search run and a logic circuit (31) for generating the station search run stop signal (SSS),
- the frequency input (FE) of the frequency circuit (32) of the stop signal generator stage (3) is connected during AM operation for generating the station search run stop signal (SSS) to a resonant circuit consisting of a pulling capacitor (C_{V}) with variable capacitance and the ceramic resonator (C_{R}), which has a resonant frequency of 456 kHz.

2. Circuit arrangement according to Claim 1, characterised in that the frequency input (FE) of the frequency circuit (32) of the stop signal generator stage (3) is connected to the pulling capacitor (C_{V}) directly and to the ceramic resonator (C_{R}) via a switching element (SE) with two switching terminals.

3. Circuit arrangement according to Claim 1, characterised in that the frequency input (FE) of the frequency circuit (32) of the stop signal generator stage (3) is connected directly to the ceramic resonator (C_{R}) and the pulling capacitor (C_{V}) used as pulling capacitor for the VCO (41) of the MPX stereo decoder stage (4).

4. Circuit arrangement according to any one of Claims 1 to 3, characterised in that the frequency circuit (32) of the stop signal generator stage (3) is formed as an AM frequency discriminator circuit.

5. Circuit arrangement according to any one of Claims 1 to 3, characterised in that the frequency circuit (32) of the stop signal generator stage (3) is formed as a selection circuit.

6. Circuit arrangement according to Claim 5, characterised in that the ceramic resonator (C_{R}) and the pulling capacitor (C_{V}) are connected in parallel in the resonant circuit, so that the parallel resonance of the ceramic resonator (C_{R}) and pulling capacitor (C_{V}) is a determining factor for the generation of the frequency signal (AFS) for the AM station search run.

7. Circuit arrangement according to Claim 5, characterised in that the ceramic resonator (C_{R}) and the pulling capacitor (C_{V}) are connected in series in the resonant circuit, so that the series resonance of the ceramic resonator (C_{R}) and pulling capacitor (C_{V}) is a determining factor for the generation of the frequency signal (AFS) for the AM station search run.

8. Circuit arrangement according to any one of Claims 1 to 7, characterised in that the pulling capacitor (C_{V}) is formed as a trimming capacitor.

9. Circuit arrangement according to any one of Claims 1 to 7, characterised in that the pulling capacitor (C_{V}) is formed as an electronic component or electronic circuit.

10. Circuit arrangement according to Claim 9, characterised in that the pulling capacitor (C_{V}) is formed as a varactor.

11. Circuit arrangement according to any one of Claims 1 to 10, characterised in that the control terminal of the pulling capacitor (C_{V}) is connected to a direct-current voltage source or direct-current source, so that the frequency is balanced when generating the frequency signal (AFS) for the AM station search run by a direct-current voltage signal (U_{St}) or direct-current signal applied to the control terminal of the pulling capacitor (C_{V}).

12. Circuit arrangement according to any one of Claims 1 to 11, characterised in that the frequency circuit (32) of the stop signal generator stage (3) generates as frequency signal (AFS) a current signal which can act on the logic circuit (31) of the stop signal generator stage (3) via a connection line (35).

13. Circuit arrangement according to Claims 1 and 12, characterised in that the logic circuit (31) of the stop signal generator stage (3) comprises a first RC element (R1, C1) for the low-frequency smoothing of the frequency signal (AFS) for the AM station search run and the frequency signal (FFS) for the FM station search run.

14. Circuit arrangement according to any one of Claims 1, 12 or 13, characterised in that the field strength signal (RS) for the AM station search run and the field strength signal (FSS) for the FM station search run are in each case formed as a current signal, and that the logic circuit (31) of the stop signal generator stage (3) comprises a second RC element (R2, C2) for the low-frequency smoothing of the frequency strength signals (FSS, RS).

15. Circuit arrangement according to Claim 1 or 14, characterised in that the logic circuit (31) comprises an adjustable resistor (R2) for varying the response threshold of the field strength signals (FSS, RS) when generating the station search run stop signal (SSS).

## Revendications

1. Montage pour un récepteur radio comportant
- un étage de réception FM (1) pour le fonctionnement en modulation de fréquence FM,
- un étage d'amplification AM (2) pour le fonctionnement en modulation d'amplitude AM,
- un étage (3) formant générateur de signaux d'arrêt pour produire un signal d'arrêt de recherche d'émetteurs (SSS) pour la recherche d'émetteurs à l'aide d'un signal d'amplification de champ (FSS, RS) et d'un signal de fréquence (FS),
- un étage de multiplexage - décodage stéréo (4) comportant un oscillateur VCO (41) commandé au moyen d'un résonateur céramique (C_{R}) fournissant une fréquence de résonance déterminée,
caractérisé en ce que
- l'étage (3) formant générateur de signaux d'arrêt comporte un circuit de production de fréquence (32) possédant une entrée de fréquence (FE) et servant à produire le signal de fréquence (AFS) pour la recherche d'un émetteur fonctionnent avec une modulation AM et un circuit logique (31) pour produire le signal (SSS) d'arrêt de recherche d'émetteurs,
- l'entrée de fréquence (FE) du circuit de production de fréquence (32) de l'étage (3) formant générateur de signaux d'arrêt est reliée, dans le fonctionnement à modulation AM, pour la production du signal (SSS) d'arrêt de recherche d'émetteurs, à un circuit résonnant formé par un condensateur d'entraînenent (C_{V}) ayant une capacité variable et par un condensateur céramique (C_{R}) qui possède une fréquence de résonance de 456 kHz.

2. Montage selon la revendication 1, caractérisé en ce que l'entrée de fréquence (FE) du circuit de production de fréquence (32) de l'étage (3) formant générateur de signaux d'arrêt est reliée directement au condensateur d'entraînement (C_{V}) et au résonateur céramique (C_{R}) par l'intermédiaire d'un élément de commutation (SE) comportant deux bornes de commutation.

3. Montage selon la revenàication 1, caractérisé en ce que l'entrée de fréquence (FE) du circuit de production de fréquence (32) de l'étage (3) formant générateur de signaux d'arrêt est reliée directement au résonateur céramique (C_{R}) et au condensateur d'entraînement (C_{V}) qui est utilisé en tant que condensateur d'entraînement pour l'oscillateur VCO (41) de l'étage de multiplexage - décodage stéréo (4).

4. Montage selon l'une des revendications 1 à 3, caractérisé en ce que le circuit de production de fréquence (32) de l'étage (3) de production de signaux d'arrêt est agencé sous la forme d'un circuit de discrimination de fréquence à modulation AM.

5. Montage selon l'une des revendications 1 à 3, caractérisé en ce que le circuit de production de fréquence (32) de l'étage (3) formant générateur de signaux d'arrêt est agencé sous la forme d'un circuit de sélection.

6. Montage selon la revendication 5, caractérisé en ce que dans le circuit résonnant, le résonateur céramique (C_{R}) et le condensateur d'entraînement (C_{V}) sont branchés en parallèle de sorte que pour la production du signal de fréquence (AFS) pour la recherche d'émetteurs à modulation AM, la résonance parallèle du résonateur céramique (C_{R}) et du condensateur d'entraînement (C_{V}) est déterminante.

7. Montage selon la revendication 5, caractérisé en ce que dans le circuit résonnant, le résonateur céramique (C_{R}) et le condensateur d'entraînement (C_{V}) sont branchés en série de sorte que pour la production du signal de fréquence (AFS) pour la recherche d'émetteurs en modulation AM, la résonance série du condensateur céramique (C_{R}) et du condensateur d'entraînement (C_{V}) est déterminante.

8. Montage selon l'une des revendications 1 à 7, caractérisé en ce que le condensateur d'entraînement (C_{V}) est agencé sous la forme d'un condensateur de réglage.

9. Montage selon l'une des revendications 1 à 7, caractérisé en ce que le condensateur d'entraînement (C_{V}) est agencé sous la forme d'un composant électronique ou d'un circuit électronique.

10. Montage selon la revendication 9, caractérisé en ce que le condensateur d'entraînement (C_{V}) est agencé sous la forme d'une diode varactor.

11. Montage selon l'une des revendications 1 à 10, caractérisé en ce que la borne de commande du condensateur d'entraînement (C_{V}) est reliée à une source de tension continue ou à une source de courant continu de sorte que l'équilibrage en fréquence lors de la génération du signal de fréquence (AFS) pour la recherche d'émetteurs en modulation AM est réalisé au moyen d'un signal de tension continue (U_{St}) ou d'un signal de courant continu, qui est appliqué à la borne de commande du condensateur d'entraînement (C_{V}).

12. Montage selon l'une des revendications 1 à 11, caractérisé en ce que le circuit de production de fréquence (32) de l'étage (3) formant générateur de signaux d'arrêt produit en tant que signal de fréquence (AFS) un signal de courant, au moyen duquel le circuit logique (31) de l'étage (3) formant générateur de signaux d'arrêt peut être chargé par l'intermédiaire d'une ligne de liaison (35).

13. Montage selon les revendications 1 et 12, caractérisé en ce que le circuit logique (31) de l'étage (3) formant générateur de signaux d'arrêt comporte, pour le lissage des basses fréquences du signal de fréquence (AFS) pour la recherche d'émetteurs en modulation AM et du signal de fréquence (FFS) pour la recherche d'émetteurs en modulation FM, comporte un premier circuit RC (R1,C1).

14. Montage selon l'une des revendications 1, 12 ou 13, caractérisé en ce que le signal d'intensité de champ (RS) pour la recherche d'émetteurs en modulation AM et le signal d'intensité de champ (FSS) pour la recherche d'émetteurs en modulation FM sont agencés respectivement sous la forme de signaux de courant, et que le circuit logique (31) de l'étage (3) formant générateur de signaux d'arrêt pour le lissage des basses fréquences des signaux d'amplification de champ (FSS, RS) comporte un second circuit RC (R2,C2).

15. Montage selon la revendication 1 ou 14, caractérisé en ce que le circuit logique (31) comporte, pour la modification du seuil de réponse des signaux d'intensité de champ (FSS, RS), lors de la production du signal (SSS) d'arrêt de recherche d'émetteurs, une résistance réglable (R2).
